**Europäisches Patentamt**

**European Patent Office**

**Office européen des brevets**

(19)

(11) Veröffentlichungsnummer : **0 038 994**
**B1**

(12) **EUROPÄISCHE PATENTSCHRIFT**

(45) Veröffentlichungstag der Patentschrift :
**15.08.84**

(21) Anmeldenummer : **81102861.2**

(22) Anmeldetag : **14.04.81**

(51) Int. Cl.³ : **H 01 L 29/52, H 01 L 21/283**

(54) Kontakt für MIS-Halbleiterbauelement und Verfahren zu seiner Herstellung.

(30) Priorität : **30.04.80 DE 3016749**

(43) Veröffentlichungstag der Anmeldung :
**04.11.81 Patentblatt 81/44**

(45) Bekanntmachung des Hinweises auf die Patenterteilung : **15.08.84 Patentblatt 84/33**

(84) Benannte Vertragsstaaten :
**CH DE FR GB IT LI SE**

(56) Entgegenhaltungen :
**DE-A- 3 015 782**
**GB-A- 2 014 787**

(73) Patentinhaber : **SIEMENS AKTIENGESELLSCHAFT**
**Berlin und München Wittelsbacherplatz 2**
**D-8000 München 2 (DE)**

(72) Erfinder : **Schuh, Gottfried**
**Boschetsrieder Strasse 138**
**D-8000 München 70 (DE)**

**Beschreibung**

Die Erfindung bezieht sich auf ein MIS-Halbleiterbauelement mit einem Substrat, in das eine erste Zone vom ersten Leitfähigkeitstyp eingebettet ist, mit einer zweiten Zone vom zweiten Leitfähigkeitstyp, die in die erste Zone eingebettet ist, mit mindestens einer auf der Substratoberfläche liegenden Isolierschicht, mit einem Kontakt, der die erste und zweite Zone durch ein in der Isolierschicht angebrachtes Loch hindurch kontaktiert.

Ein solches Halbleiterbauelement ist in Form eines MOS-Feldeffekttransistors mit Vertikalstruktur bereits beschrieben worden. Dabei liegt die die Kanalzone bildende erste Zone und die Source bildende zweite Zone an der Oberfläche des Substrats, während die Drainzone das Substrat an der Unterseite großflächig bedeckt. Zur Erzielung guter elektrischer Eigenschaften, zum Beispiel einer niedrigen Einsatzspannung, muß der Kanal kurz gehalten werden. Auch muß die die Sourcezone bildende zweite Zone sehr dünn gemacht werden. Zudem kann sie nicht sehr hoch dotiert werden, da sonst eine Unterdiffusion der als Maskierung dienenden Isolierschicht eintreten würde. Damit könnte die Kanallänge jedoch nicht mehr reproduzierbar gestellt werden.

Ferner ist in der GB-A 2 014 787 eine MIS-Struktur beschrieben worden, bei der zwei von einer Isolierenschicht abgedeckte übereinanderliegende Zonen entgegengesetzten Leitungstyps mittels eines bis in die untere Zone reichenden Loches durch die Isolierschicht und durch die obere Zone kontaktiert werden.

Die Kontaktierung einer solchen dünnen, relativ schwach dotierten Schicht mit dem üblicherweise als Kontakt verwendeten Aluminium oder einer Aluminium-Siliciumlegierung stößt nun insbesondere dann auf Schwierigkeiten, wenn die Sourcezone n-leitend ist, da Aluminium im Silicium p-dotierend wirkt.

Die Erfindung liegt die Aufgabe zugrunde, ein MIS-Halbleiterbauelement der eingangs erwähnten Art so weiterzubilden, daß eine einwandfreie Kontaktierung auch relativ schwach dotierter, dünner Zonen mit einem Metall möglich ist, das im Silicium die entgegengesetzte Dotierung verursachen würde.

Die Erfindung ist dadurch gekennzeichnet, daß die zweite Zone ein Kontaktloch aufweist, durch die der Kontakt hindurchgeht und mit der ersten Zone verbunden ist, daß die zweite Zone mit dem Kontakt über eine den Kontakt umgebende Hilfszone elektrisch verbunden ist, und daß die Hilfszone gleichen Leitfähigkeitstyp, jedoch höhere Dotierung als die zweite Zone hat.

Weiterbildungen der Erfindung sind Gegenstand der Unteransprüche. Ein Verfahren zum Herstellen eines solchen Halbleiterbauelements ist Gegenstand des Verfahrensanspruchs.

Die Erfindung wird an hand eines Ausführungsbeispiels in Verbindung mit den Fig. 1 bis 5 näher erläutert. Es zeigen:

Figur 1 den Schnitt durch einen fertigen MIS-FET und

Figuren 2 bis 5 den Schnitt durch den MIS-FET während verschiedener, aufeinanderfolgender Verfahrensschritte.

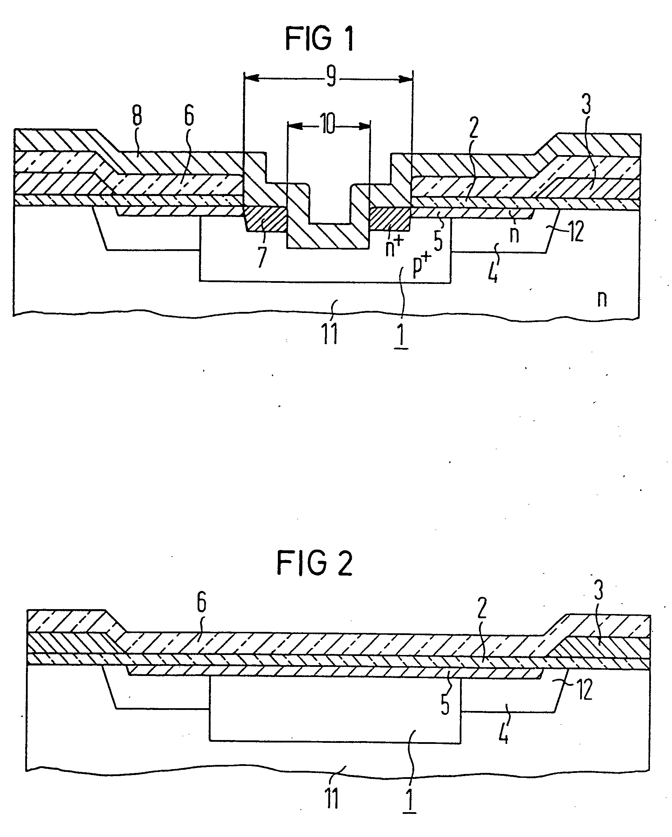

Der FET nach Fig. 1 weist ein n-leitendes Substrat 11 auf, in das eine p-leitende erste Zone 1 planar eingebettet ist. In die erste Zone 1 ist eine zweite Zone 5 planar eingebettet, die die Source bildet. Diese Zone ist n-leitend. Die Oberfläche des Substrats ist mit einer ersten Isolierschicht 2 bedeckt, die üblicherweise aus Siliciumdioxid $SiO_2$ besteht. Die erste Zone 1 weist einen Abschnitt 4 auf, der an die Substratoberfläche tritt und dort eine Kanalzone 12 bildet. Die Kanalzone 12 und der unverändert gebliebene Teil des Substrats 11 ist mit einer Steuerelektrode 3 bedeckt, die aus n-dotiertem, polykristallinem Silicium aufgebaut ist. Die Isolierschicht 2 und die Steuerelektrode 3 ist mit einer zweiten Isolierschicht 6 bedeckt, die ebenfalls eine $SiO_2$-Schicht sein kann. Die zweite Zone 5 ist mit einer Hilfszone 7 verbunden, die gleichen Leitfähigkeitstyp wie die zweite Zone 5 aufweist, jedoch höher als diese dotiert ist. Im Ausführungsbeispiel ist die Hilfszone 7 stark n-dotiert. Die gesamte Oberfläche des FET ist mit einer Kontaktschicht 8 bedeckt, die aus Aluminium oder einer Aluminium-Siliciumlegierung bestehen kann. Diese kontaktiert die Zone 1 durch ein Kontaktloch 10. Die Hilfszone 7 wird am Umfang durch dasselbe Kontaktloch und an der Oberfläche durch ein in den Isolierschichten 2 und 6 geöffnetes Kontaktloch 9 kontaktiert. Durch die Hilfszone 7 wird ein einwandfreier Kontakt zwischen der Kontaktschicht 8 und der Quelle 5 erreicht.

Der FET nach Fig. 1 wird zweckmäßigerweise folgendermaßen hergestellt:

In das n-leitende Substrat 11 wird zunächst der tiefe zentrale Teil der ersten Zone 1 eindiffundiert (Fig. 2). Die Eindiffusion kann auf übliche Weise durch photomaskierung oder auch durch Beschuß mit Borionen und nachfolgendes Eintreiben in das Substrat erzeugt werden. Anschließend wird das Substrat ganzflächig mit der Siliciumdioxidschicht 2 bedeckt. Dann wird auf der Schicht 2 die Steuerelektrode 3 derart aufgebracht, daß sie den zentralen Teil der Zone 1 nicht überdeckt. Die Steuerelektrode 3 besteht aus n-leitendem, polykristallinem Silicium, das aus einer gasförmigen Verbindung des Siliciums abgeschieden wird. Dieses wird an den Flanken schräggeätzt. Als nächstes wird der Abschnitt 4 mit der Steuerzone 12 durch Beschuß mit Borionen und entsprechend weniger tiefes Eintreiben in das Substrat hergestellt. Die Steuerelektrode 3 wirkt für den Ionenbeschuß als Maske, so daß sich die dargestellte, schräg zur Oberfläche des Substrats verlaufende Form der Kanalzone einstellt. Anschließend daran wird die zweite Zone 5 durch Implantieren und Eintreiben zum Beispiel von Arsen-Ionen erzeugt. Dann wird die gesamte Oberfläche mit der zweiten Isolierschicht 6 aus Siliciumdioxid versehen. Dazu kann wiederum Silicium aus einer gasförmigen Verbindung des Siliciums auf der Oberfläche abgeschieden und durch nachfolgendes Oxydieren in das Siliciumdioxid umgewandelt werden.

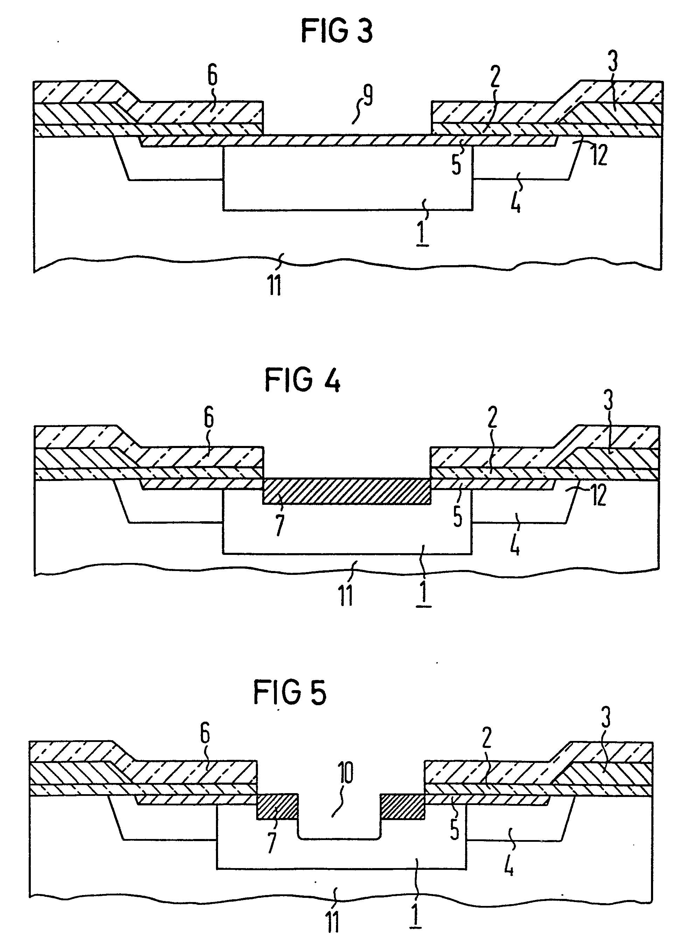

In Fig. 3 ist dargestellt, daß in die Isolierschichten 2 und 6 das Kontaktloch 9 eingeätzt wird. Der Ätzvorgang wird dann unterbrochen, wenn die Oberfläche der zweiten Zone 5 freiliegt. Im Anschluß daran (Fig. 4) wird die ganze Oberfläche der Anordnung einer phosphorhaltigen Atmosphäre unter hoher Temperatur ausgesetzt. Dies bewirkt einerseits, daß das freiliegende Teil der zweiten Zone 5 höher dotiert und tiefer in die erste Zone 1 hineingetrieben wird. Dieses Teil bildet die Hilfszone 7. Andererseits bewirkt die Temperaturbehandlung in phosphorhaltiger Atmosphäre eine Verrundung von Kanten und Auffüllung von Fehlstellen in der zweiten Isolierschicht 6, was als « Oxid-Reflow »-Verfahren seinen Eingang in die Halbleitertechnik gefunden hat.

Wie aus Fig. 5 ersichtlich, wird anschließend daran in die Zone 7 das Kontaktloch 10 derart hineingeätzt, daß es nur ringsum von dem Rest der Hilfszone 7 umgeben ist. Die Ätzung kann so weit vorangetrieben werden, daß das Kontaktloch tiefer als die Dicke der Hilfszone 7 ist, unbedingt notwendig ist dies jedoch nicht. Es ist auch nicht unbedingt notwendig, daß die Hilfszone 7 dicker als die zweite Zone 5 ist. Zur Erreichung einer guten Kontaktierung ist es lediglich erforderlich, daß die Hilfszone 7 höher als die Zone 5 dotiert ist und daß die Oberfläche der ersten Zone 1 frei liegt. Nach dem Einätzen der Aussparung 10 wird die Oberfläche der ganzen Anordnung dann mit einer Schicht aus Aluminium oder einer Aluminium-Siliciumlegierung versehen, wie in Fig. 1 dargestellt. Damit ist eine einwandfreie Kontaktierung der Zone 1 und der Quelle des FET gewährleistet.

Die Hilfszone 7 kann beispielsweise eine Dotierung von etwa $3 \cdot 10^{20}$ und eine Tiefe von 0,5 bis 1 μm aufweisen. Die Dicke der Zone 5 kann dagegen bei 0,15 bis 0,2 μm liegen. Ihre Dotierung kann 1 bis $5 \cdot 10^{18}$ betragen. Diese wird durch eine Arsenimplantation mit einer Energie von 120 keV und einer Dosis von $5 \cdot 10^{14}$ cm$^{-2}$ eingestellt.

Die Erfindung wurde an hand eines FET beschrieben. Sie ist jedoch auch für durch Feldeffekt steuerbare Thyristoren, Triacs und allgemein für alle Arten von vertikalen MIS-Strukturen anwendbar.

## Ansprüche

1. MIS-Halbleiterbauelement mit einem Substrat, in das eine erste Zone vom ersten Leitfähigkeitstyp eingebettet ist, mit einer zweiten Zone vom zweiten Leitfähigkeitstyp, die in die erste Zone eingebettet ist, mit mindestens einer auf der Substratoberfläche liegenden Isolierschicht, mit einem Kontakt, der die erste und zweite Zone durch ein in der Isolierschicht angebrachtes Loch hindurch kontaktiert, dadurch gekennzeichnet, daß die zweite Zone (5) ein Kontaktloch (10) aufweist, durch die der Kontakt (8) hindurchgeht und mit der ersten Zone (1) verbunden ist — wie an sich bekannt — und daß die zweite Zone (5) mit dem Kontakt (8) über eine den Kontakt umgebende Hilfszone (7) elektrisch verbunden ist, und daß die Hilfszone (7) gleichen Leitfähigkeitstyp, jedoch höhere Dotierung als die zweite Zone (5) hat.

2. Halbleiterbauelement nach Anspruch 1, dadurch gekennzeichnet, daß das Kontaktloch (10) in die erste Zone (1) hineinreicht.

3. Halbleiterbauelement nach Anspruch 1 oder 2, dadurch gekennzeichnet, daß die Hilfszone (7) größere Dicke als die zweite Zone (5) hat.

4. Halbleiterbauelement nach einem der Ansprüche 1 bis 3, dadurch gekennzeichnet, daß die Hilfszone (7) auch an der Oberfläche kontaktiert ist.

5. Verfahren zum Herstellen eines Halbleiterbauelements nach Anspruch 1 bis 4, gekennzeichnet durch folgende Schritte :

a) in ein n-leitendes Substrat wird ein zentraler Teil einer p-leitenden planaren ersten Zone (1) eindiffundiert,

b) auf der Substratoberfläche wird ganzflächig eine aus Siliciumdioxid bestehende erste Isolierschicht (2) erzeugt,

c) auf der Isolierschicht (2) wird eine aus n-dotiertem polykristallinem Silicium bestehende Steuerelektrode (3) derart aufgebracht, daß ein Teil des unveränderten Substrats bedeckt ist,

d) in dem Substrat wird die Kanalzone (12) durch Ionenbeschuß und nachfolgende Temperaturbehandlung erzeugt,

e) in der ersten Zone (1) wird die zweite Zone (5) durch Ionenbeschuß und nachfolgende Temperaturbehandlung erzeugt,

f) auf der ersten Isolierschicht (2) und der Steuerelektrode (3) wird ganzflächig eine zweite, aus Siliciumdioxid bestehende Isolierschicht (6) aufgebracht,

g) beide Isolierschichten werden bis auf die Oberfläche der zweiten Zone (5) durchgeätzt,

h) die gesamte Oberfläche wird in einer phosphorhaltigen Atmosphäre erhitzt, bis der freiliegende Teil der zweiten Zone (5) höher dotiert ist als der von den Isolierschichten bedeckte,

i) in den höher dotierten Teil (7) der zweiten Zone (5) wird ein Kontaktloch (10) geätzt, bis die Oberfläche der ersten Zone (1) frei liegt,

j) auf die gesamte Oberfläche der Anordnung wird eine Kontaktschicht (8) aufgebracht.

## Claims

1. An MIS semiconductor component comprising a substrate in which a first zone of the first conductivity type is embedded, a second zone of the second conductivity type which is embedded in the first zone, at least one insulating layer arranged on the substrate surface, and a contact which contacts the first and second zones through an aperture in the insulating layer, characterised in that the second zone (5) has a contact aperture (10), through which the contact (8) passes and is connected to the first zone (1) in known manner ; that the second zone (5) is electrically connected to the contact (8) by means of an auxiliary zone (7) surrounding the contact ; and that the auxiliary zone (7) has the same conductivity type but a higher doping than the second zone (5).

2. A semiconductor component according to Claim 1, characterised in that the contact aperture (10) extends into the first zone (1).

3. A semiconductor component according to claim 1 or Claim 2, characterised in that the auxiliary zone (7) has a greater thickness than the second zone (5).

4. A semiconductor component according to one of Claims 1 to 3, characterised in that the auxiliary zone (7) is also contacted at the surface.

5. A process for the production of a semiconductor component according to Claim 1 to 4, characterised by the following steps :

a) a central part of a p-conducting planar first zone (1) is diffused into an n-conducting substrate,

b) a first insulating layer (2) consisting of silicon dioxide is produced on the substrate surface over its whole area,

c) a control electrode (3), consisting of n-doped polycrystalline silicon, is applied on the insulating layer (2) in such a way that a part of the unchanged substrate is covered,

d) in the substrate, the channel zone (12) is produced by ion bombardment and subsequent heat treatment,

e) the second zone (5) is produced by ion bombardment and subsequent heat treatment, in the first zone (1),

f) a second insulating layer (6) consisting of silicon dioxide, is applied on the first insulating layer (2) and the control electrode (3) over the whole area,

g) both insulating layers are etched through to the surface of the second zone (5),

h) the entire surface is heated in a phosphorus atmosphere until the exposed part of the second zone (5) has a higher doping than the part covered by the insulating layers,

i) a contact aperture (10) is etched into the more highly doped part (7) of the second zone (5) until the surface of the first zone (1) is exposed,

j) a contact layer (8) is applied over the entire surface of the arrangement.

**Revendications**

1. Composant à semiconducteurs MIS, avec un substrat dans lequel est noyée une première zone du premier type de conductibilité, avec une seconde zone du second type de conductibilité, qui est noyée dans la première zone, avec au moins une première couche isolante située sous la surface du substrat, avec un contact qui contacte la première et la seconde zone à travers un trou ménagé dans la couche isolante, caractérisé par le fait que la seconde zone (5) présente un trou de contact (10) à travers lequel passe le contact et est reliée avec la première zone (1) — comme connu en soi —, que la seconde zone (5) est reliée électriquement avec le contact (8) par l'intermédiaire d'une zone auxiliaire (7) qui entoure le contact, et que la zone auxiliaire (7) possède le même type de conductibilité que la seconde zone (5), mais possède un dopage plus prononcé.

2. Composant à semiconducteurs selon la revendication 1, caractérisé par le fait que le trou de contact (10) s'étend dans la première zone (1).

3. Composant à semiconducteurs selon la revendication 1 ou 2, caractérisé par le fait que la zone auxiliaire (7) a une épaisseur plus forte que celle de la seconde zone (5).

4. Composant à semiconducteurs selon l'une des revendications 1 à 3, caractérisé par le fait que la zone auxiliaire (7) est également contactée au niveau de la surface.

5. Procédé pour la fabrication d'un composant à semiconducteurs selon la revendication 1 à 4, caractérisé par les phases opératoires suivantes :

a) dans un substrat de conductibilité n, on réalise par diffusion, une partie centrale d'une première zone planaire (1) de conductibilité p,

b) sur la surface du substrat on produit, une première couche isolante (2), d'un seul tenant, et constituée par du bioxyde de silicium,

c) sur la couche isolante (2) on réalise de telle manière une électrode de commande qui est constituée par du silicium polycristallin dopé en n, qu'une partie du substrat non modifiée est recouverte,

d) dans le substrat, on produit la zone de canal (12) par bombardement ionique suivi d'un traitement thermique,

e) dans la première zone (1) on produit la seconde zone (5) par bombardement ionique suivi d'un traitement thermique,

f) sur la première couche isolante (2) et sur l'électrode de commande (3), on dépose, sur toute la surface, une seconde couche isolante (6) qui est constituée par du bioxyde de silicium,

g) les deux couches isolantes sont attaquées jusqu'à la surface de la seconde zone (5),

h) la totalité de la surface est chauffée dans une atmosphère à teneur de phosphore jusqu'à ce que la partie de la seconde zone (5) qui est dégagée soit dopée de façon plus prononcée que ne l'est la partie qui est recouverte par les deux couches isolantes,

i) dans la partie (7) plus fortement dopée, de la seconde zone (5) on réalise par attaque un trou de contact (10) jusqu'à ce que la surface de la première zone (1) soit dénudée,

j) sur la totalité de la surface du dispositif, on dépose une couche de contact (8).

## FIG 1

## FIG 2

0 038 994

## FIG 3

## FIG 4

## FIG 5